# EUROPEAN PATENT APPLICATION

(11) **EP 0 688 054 A2**
(43) Date of publication of application: **20.12.1995**
(21) Application number: 95303736.3
(22) Date of filing: 01.06.1995
(51) Int. Cl.: H01L 27/02

(54) **Electrostatic discharge protection for integrated circuit semiconductor device**

(30) Priority: 13.06.1994 US 259239
(71) Applicant: SYMBIOS LOGIC INC., Fort Collins, Colorado 80525 (US)
(72) Inventor: Nguyen, Hoang, Fort Collins, Colorado 80526 (US); Walker, John D., Colorado Springs, Colorado 80907 (US)
(74) Representative: Gill, David Alan

(57) **Abstract**

The invention provides for a thick field device for protecting an integrated circuit against electrostatic discharge damage. The thick field device comprises two PN junctions (21, 23) separated by a field oxide (27), and operates as a lateral bipolar transistor with a floating base. Implantation of a controlled concentration of dopant (29) under the field oxide (27) lowers trigger voltage. A well extension (37) provided below metal contacts (31, 33) minimizes effects of junction spiking and a metal contact configuration (31) that extends over the field oxide (27) provides a barrier against ion migration which would otherwise degrade leakage current.

## Description

The present invention relates to integrated circuit semiconductor devices and in particular, but not exclusively, to an electrostatic discharge protection device for use in such circuits.

Electrostatic discharge (ESD) phenomena commonly result from pulses of high voltage (typically, several kilovolts), moderate current (a few amperes) and short duration (on the order of 100 nanoseconds) generated by a variety of sources such as human bodies, electric fields generated by machinery, and the like.

ESD effects are a common problem in integrated circuit (IC) electronics and are particularly troublesome in complimentary metal oxide semiconductor (CMOS) devices which have particularly thin gate oxides, and also very short channel devices. Such structures typically can withstand only a few tens of volts. An ESD pulse conducted through a CMOS IC can induce oxide rupture and device or interconnect burnout. An ESD pulse can also induce a "latch-up" condition in thick field devices.

ESD problems can be abated somewhat by including appropriate anti-static protection on the circuit boards on which the ICs are installed; however, the ICs still are susceptible to ESD before and during the circuit board fabrication process. A general personnel awareness of ESD problems and countermeasures such as electrically grounded bracelets and the like reduce risks in this phase of the IC life span; however, it is at best a partial solution. Therefore, it is desirable to include ESD protection circuitry within the IC itself.

One prior art ESD protection circuit involves the use of a resistor interposed between an IC chip bonding pad or terminal and internal IC circuitry. By dropping a portion of the input signal across the resistor, much of the ESD voltage can be dissipated. The CMOS latch-up current can be reduced as well. Unfortunately, the combination of the input resistor and the parasitic capacitance of the bonding pad and input line together generate a significant RC time delay which limits the speed at which the IC operates.

Another prior art solution has been to use diodes to shunt the ESD current to ground. This approach has its drawbacks. Such diodes typically have a significant parasitic series resistance which limits the amount of current that may be shunted. Furthermore, the forward current increases with temperature due to the increased saturation current and due to the reduced semiconductor band gap. Thus, heating that results from an ESD event further limits current carrying capability. Large area diodes may be used to reduce this resistance; however, this variation reduces the chip density and increases the input circuit's capacitance.

The present invention seeks to provide means for protecting against ESD which has advantages over known such means.

According to the present invention, there is provided a thick field device for limiting a voltage between first and second conduction paths to below a required level characterised by first and second semiconductor regions of a first dopant type separated by a third semiconductor region of a second dopant type, the first semiconductor region being arranged for connection to the first conduction path at a first contact location, the second semiconductor region being arranged for connection to the second conduction path at a second contact location a field oxide region overlying the third semiconductor region and a field implant region provided within the third semiconductor region, the field implant region having a concentration of the second dopant type sufficient to reduce a trigger voltage of the thick field device to below said required level.

Advantageously, the present invention provides an integrated circuit with improved ESD protection.

The integrated circuit can advantageously include a thick field device providing ESD protection.

The invention may also provide for a thick field device especially suitable for protecting an integrated circuit against ESD.

Advantageously, the invention can provide a thick field device with switching and current handling capabilities suitable for protecting integrated circuits against ESD.

Further, the thick field device can readily have temperature stability properties suitable for protecting integrated circuits against ESD.

An advantageously simple and effective operation is achieved by a thick device with a field implant which reduces turn-on voltage to a level suitable for ESD protection.

Preferably, wells can be provided to extend the depth of the first semiconductor region.

Then the invention can provide for a thick field device with reduced susceptibility to formation of junction spikes during heating attendant to ESD current conduction.

Preferably a metal layer is arranged to extend over the field oxide region, which layer may advantageously comprise an extension of a metal connector.

The invention is then advantageous in providing a thick field device with reduced susceptibility to diffusion of ions from interlayer dielectric film to the field oxide/silicon interface during heating attendant to ESD current conduction, and with isolation from effects of mobile ion contamination in the overlying interlayer dielectric film.

In particular, the invention can provide a thick field device with: 1) a thick field implant to adjust trigger voltage; 2) a VSS metal plate located above and between the emitter and collector to prevent high-temperature, sodium ion diffusion and to prevent device inversion and leakage from ion contamination in the overlying interlayer dielectric film; and 3) a relatively deep N well beneath metal junctions so that silicon diffusion into metal does not create a spike that penetrates to an underlying P region.

The thick field devices of the present invention provide better leakage characteristics than diodes at high temperature, controlled trigger characteristics, reduced resistance and power dissipation, reduced likelihood of sodium contamination, and minimum junction spiking.

The invention is described further hereinafter, by way of example only, with reference to the accompanying drawings in which :
FIG. 1A is a cross section of a thick field device of the present invention;
FIG. 1B is a graph showing the voltage-current characteristics of the device of FIG. 1A;
FIG. 2A is a top view showing layout of regions of a thick field device of the present invention;
FIG. 2B is a layout of N wells for L-shaped thick field devices in an IC corner;
FIGS. 3-7 are cross sections of an integrated circuit at various stages of fabrication showing a process for making an integrated circuit with thick field device of the present invention;
FIG. 8 is graph showing a profile of dopant concentration in a thick field implant region at various dopant concentrations;
FIG. 9 is a graph showing trigger and hold voltages for a thick field device as functions of field implant dose and N+ to N+ spacing;
FIG. 10 is a graph showing breakdown voltage and field threshold voltage for N-type devices with a field implant and for P-type devices without a field implant;
FIG. 11 is a graph showing current/voltage relationships for thick field devices with and without field implants;
FIG. 12 is a current/voltage characteristics for a repeatedly-stress thick field device with field implant;
FIG. 13 is a two-part table showing trigger voltage and holding voltage for batches of thick field devices for varying combinations of field implant doses and N+ implant doses;
FIG. 14 is a table showing leakage current and breakdown voltage for thick field devices with and without field implants;
FIG. 15 is an illustration of a junction spike resulting from silicon migration into an aluminum contact during ESD heating;
FIG. 16 is an illustration of sodium ion migration under conditions of ESD stress; and
FIG. 17 is schematic diagram for an application of a thick field device in an integrated circuit for ESD protection.

Although a few preferred embodiments of the invention are shown and described below, it will be appreciated by those skilled in the art that changes may be made in these embodiments without departing from the principles and the spirit of the invention, the scope of which is defined in the appended claims.

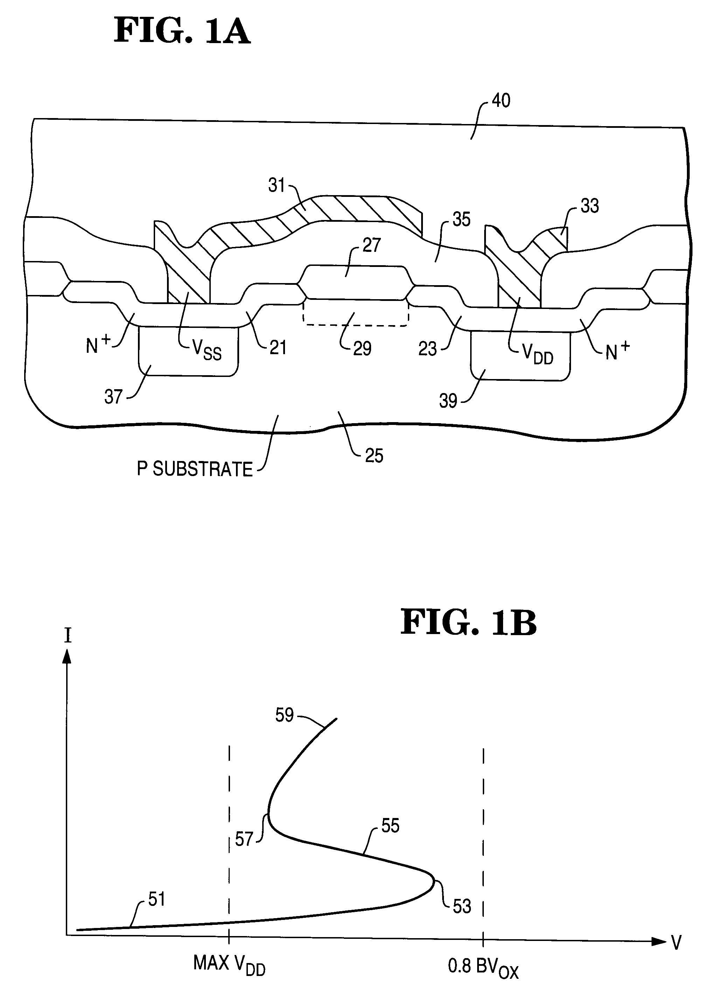

FIG. 1A is a cross section of a thick field device of the present invention formed by first and second N+ regions 21, 23 (emitter and collector) separated by a P region 25 (base) and field oxide 27. A region of increased P-type dopant 29 is located under the field oxide 27. The field oxide 27 and active N+ regions 21, 23 are covered by a layer of BPSG 35. The device is two N+ junctions separated by a field oxide within a P well, and operates as a lateral NPN bipolar device with floating base. Of course, it will be understood that a complimentary device can be formed as two P+ junctions in an N well.

One of the N+ regions 21 connects to a metal conduction path 31, which in turn connects to a Vss IO pad (not shown). The other N+ region 23 connects to a metal conduction path 33 which in turn connects to a VDD IO pad (not shown). The metal layers 31, 33 and otherwise exposed glass layer 35 are covered by an interlayer dielectric 40 and additional layers of metal and dielectric (not shown).

It should be noted that the VSS metal layer 31 is widened to extend over field oxide 27. As will be discussed more fully below, this extension limits MOS channel inversion and leakage due to ions in the overlying interlayer dielectric film, and limits ion migration from the interlayer dielectric to the field oxide.

It should also be noted that two N-well extensions are also provided, one under each N+ region where they connect to metal conduction paths 31, 33. As will also be discussed more fully below, silicon migrates into the metal layers when heated during an ESD event. The depletion of silicon on the N+ region might otherwise result in a junction spike connecting the metal layer to the underlying P substrate.

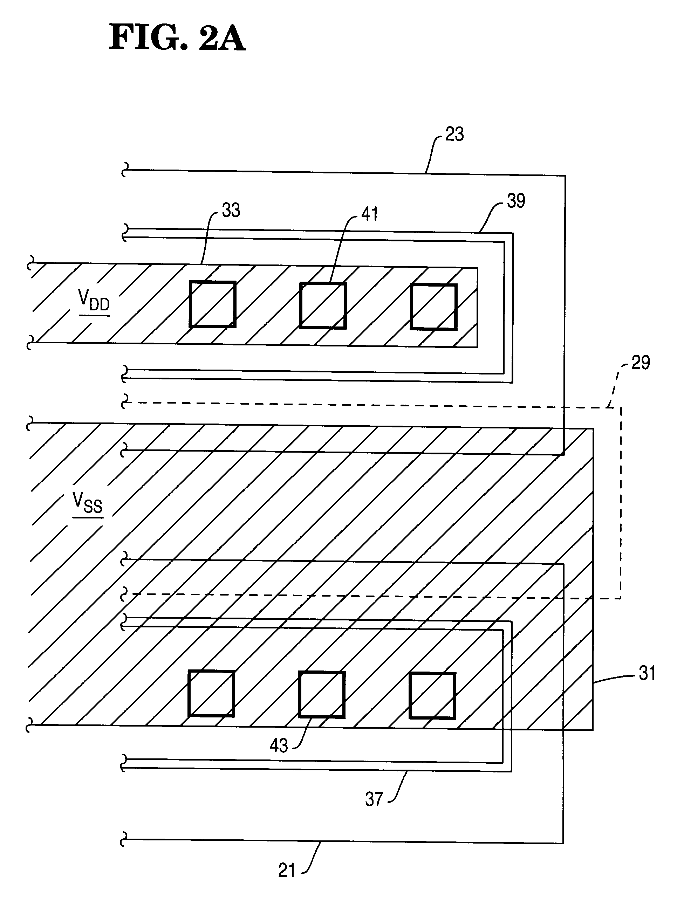

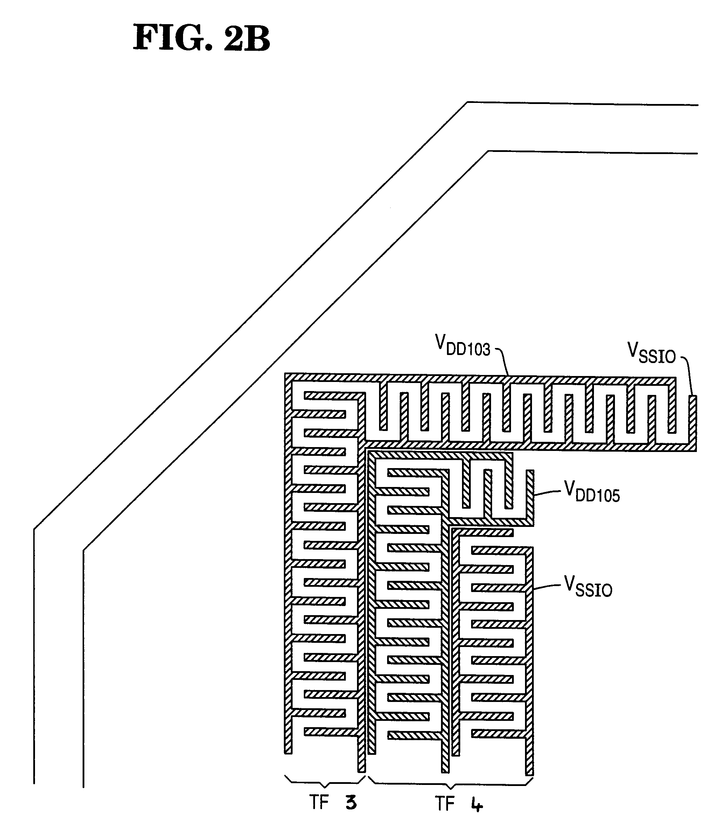

FIG. 2A is a top view showing layout of regions of a thick field device of FIG. 1A. Elongated N+ regions 21, 23 can be seen separated by the region of increase P-type dopant 29. The N-well extensions 37, 39 can also be seen under the contacts 41, 43 to metal layers 33 (for VDD) and 31 (for VSS). The VSS metal layer 31 extends over the region of increased P-type dopant 29 and field oxide (not shown). FIG. 2B shows an L-shaped layout in a corner for two back-to-back thick field devices. (Outlines shown are N well regions.)

FIG. 1B is a graph showing the voltage-current characteristic for the thick field device of FIG. 1A. During normal operation, the voltage VDD remains below the level MAX VDD. The thick field device is in an off state 51 and conducts only a small leakage current. During an ESD event, the voltage VDD exceeds the normal operating level and reaches a trigger voltage 53. The thick field device switches on, conducts current, and enters a negative resistance region 55. Resistance drops, current increases, and voltage decreases to a holding voltage 57. The device is capable of conducting increasing amounts of current 59 during the ESD event without failing.

Other devices on the integrated circuit, such as CMOS logic circuits, have a characteristic voltage level at which they may be damaged. Although the failure mechanism is not important to the invention, one example is the oxide breakdown voltage BVOX. Gate oxide breakdown voltage is approximately 10 megavolts/cm. For a 140 angstrom gate, BVOX is approximately 14 volts. In order to provide a safety margin, it is desirable to have a trigger at or below 80% of BVOX. Thus, to prevent gate oxide rupture within the circuit during an ESD event, the maximum thick field device trigger voltage should be approximately 11.2 volts.

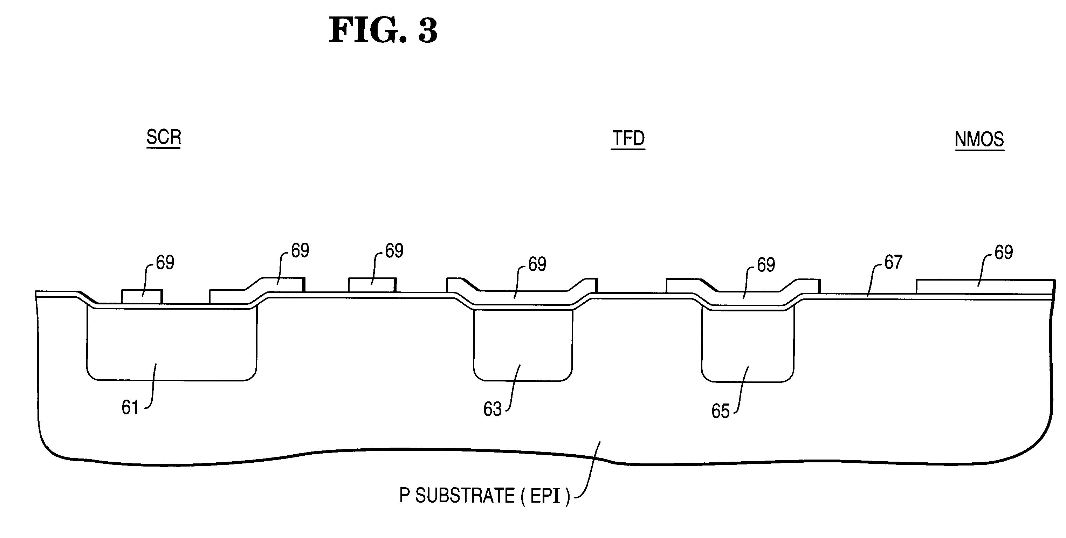

FIGS. 3-7 are cross sections of an integrated circuit at various stages of fabrication showing a process for making an integrated circuit with thick field device of the present invention. Three devices are shown: a silicon controlled rectifier (SCR), a thick field device (TFD) and an NMOS transistor (NMOS).

As seen from FIG. 3, the devices are formed in a P-substrate, epitaxial wafer with an intrinsic dopant concentration of about 1E16/cm3. A single N well 61 is formed for the SCR, while twin wells 63 and 65 are formed using a "twin tub process" for the thick field device. N wells are formed by implanting N-type dopant to achieve a concentration of about 1E16 to 1E17/cm3 to a depth of about two microns.

A thin (e.g., 300 angstrom) oxide layer 67 is then formed over all areas, followed by a thicker (1600 angstrom) nitride layer 69. The nitride is masked and etched to expose active regions for SCR, TFD and NMOS devices.

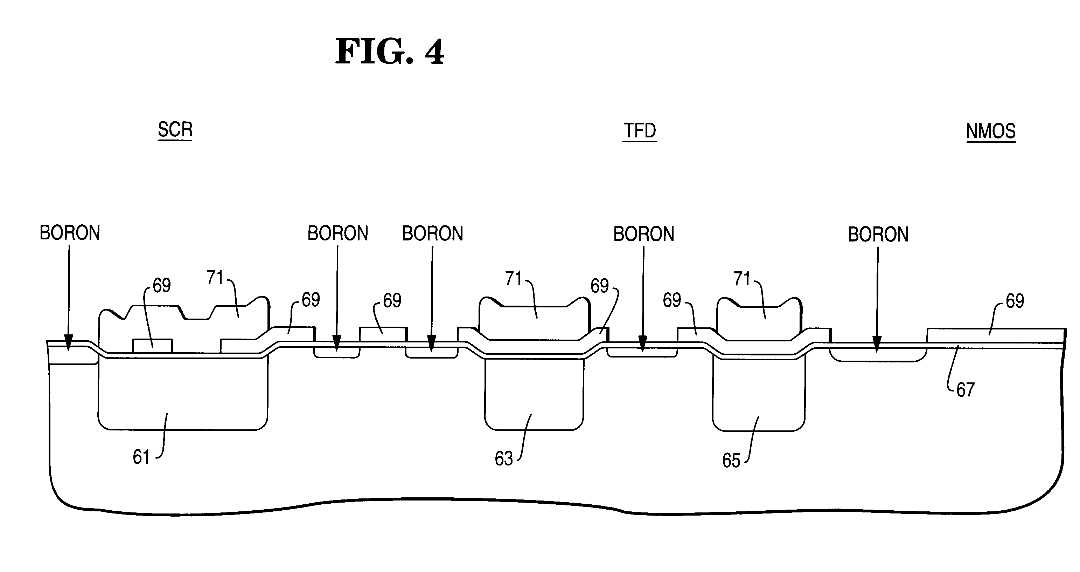

As seen from FIG. 4, a photoresist mask layer 71 is applied and patterned to expose substrate regions which will receive a 30 keV boron implant to bring dopant concentration up to about 3E13/cm2.

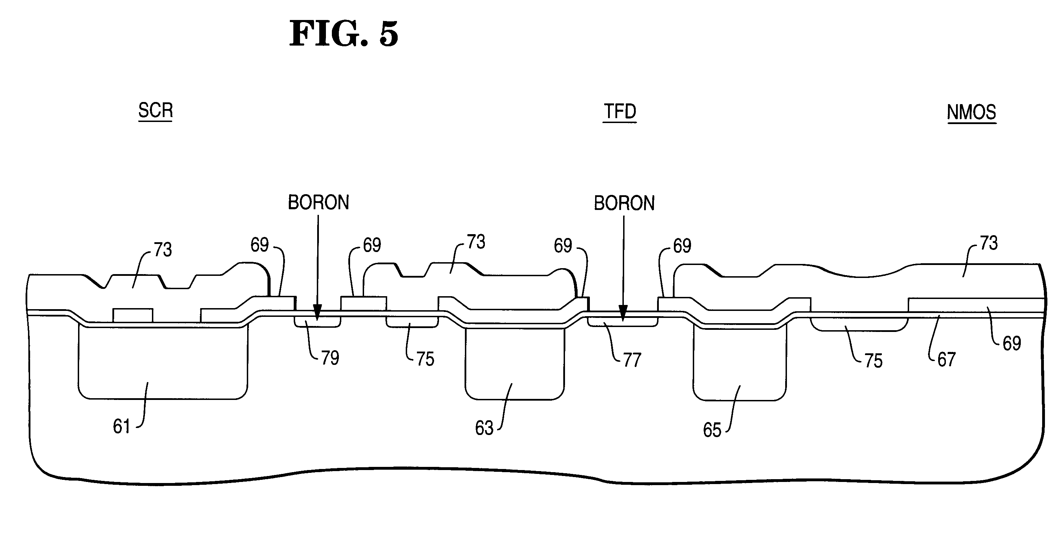

As seen from FIG. 5, a second photoresist mask is applied and patterned to expose selective regions of the SCR and the TFD for an additional boron implant at about 40 keV to bring dopant concentration up to about 1.7E14/cm2. After this second implant, most field regions 75 will have a first, lower boron concentration, while the TFD and SCR will have specific regions 77,79 with higher concentrations. The purpose and operation of these higher concentrations will be discussed more fully below.

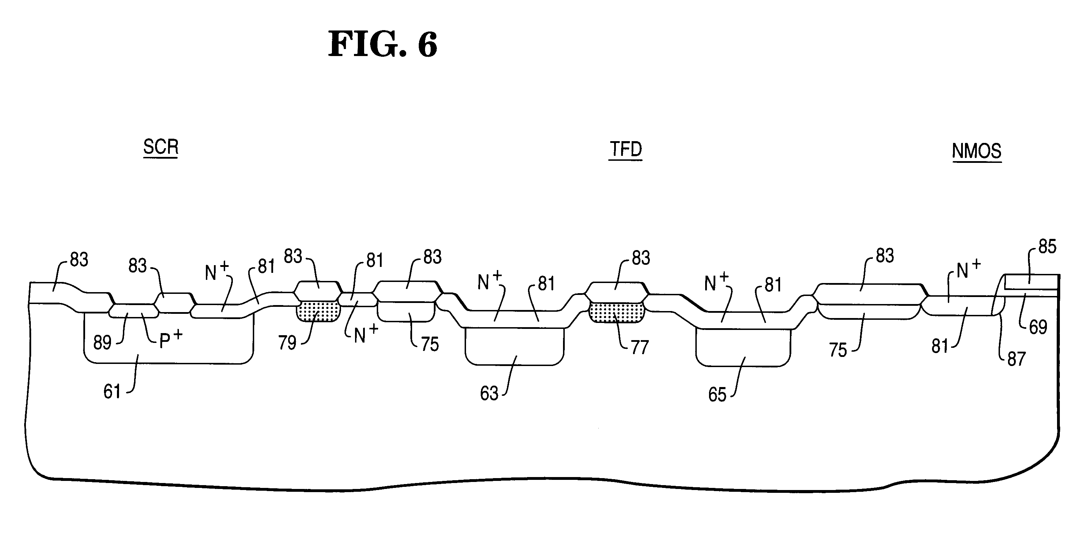

As seen from FIG. 6, field oxides 83 are then grown to thicknesses of about 5000 angstroms, and poly-crystalline gate contacts 85 are formed. Additional mask and implant steps are carried out to form active N+ regions 81 to a depth of about 0.25 microns, and active P+ regions 89 to a depth of about 0.3 microns. Optionally, the process steps can be adjusted to provide lightly doped drain regions 87 using a sidewall spacer technique.

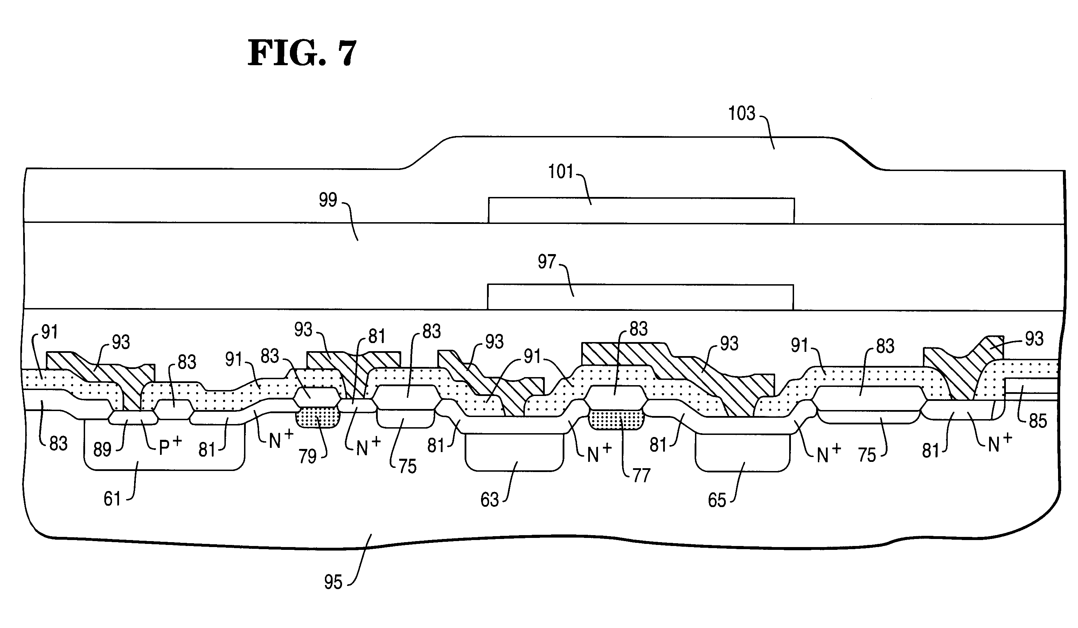

As seen from FIG. 7, a layer 91 of borophososilicate glass (BPSG) is deposited, through which holes are etched for metal contacts to a first metal layer 93. A first interlayer dielectric 95 is applied and followed by a second metal layer 97. A second interlayer dielectric 99 is applied, followed by a second metal layer 101 and a passivation layer 103.

As discussed above with reference to FIG. 1A, the thick field device is an NPN transistor with a floating gate. It is desirable to adjust the trigger voltage of the thick field device so that its turn-on voltage is about 80% of the voltage at which other devices on the integrated circuit become damaged. The trigger voltage is adjusted by controlling the field implant dopant concentration in a field implant region 29 (FIG. 1), 77 (FIG. 7) under the field oxide.

The effect of the field implant can be appreciated once it is recognized that the junction breakdown voltage of a semiconductor diode is an inverse function of the dopant concentration in the diode. Junction breakdown is the trigger mechanism for the thick field device. Thus, increasing concentration under the field oxide reduces trigger voltage. This is accomplished in the second boron implant, shown in FIG. 5 for TFD region 79. (A lower concentration field implant is used elsewhere to prevent field inversion.)

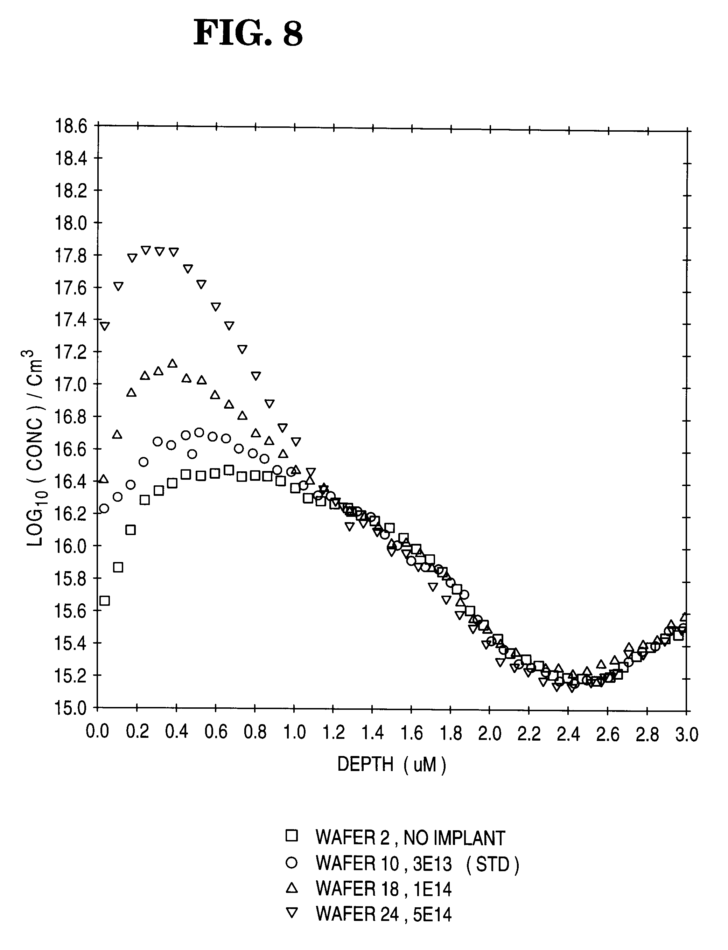

FIG. 8 is graph showing a depth profile of boron dopant concentration in a thick field implant region under a field oxide at various dopant concentrations.

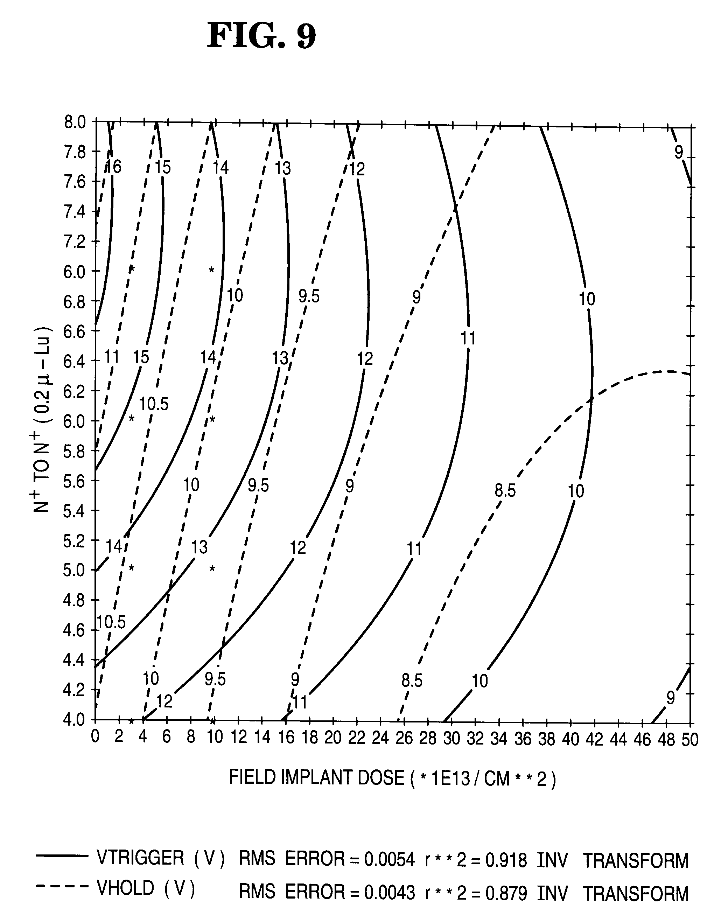

FIG. 9 is a graph showing trigger and hold voltages for a thick field device as functions of field implant dose and N+ to N+ spacing (Δ d). Spacing is shown on the vertical axis in layout units, each of which corresponds to 0.2 microns in this example. As can be seen from the solid lines, for a fixed separation between N+ regions in the thick field devices, increasing filed implant dose lowers trigger voltage. The dashed lines show that increasing field implant dose also lowers hold voltage.

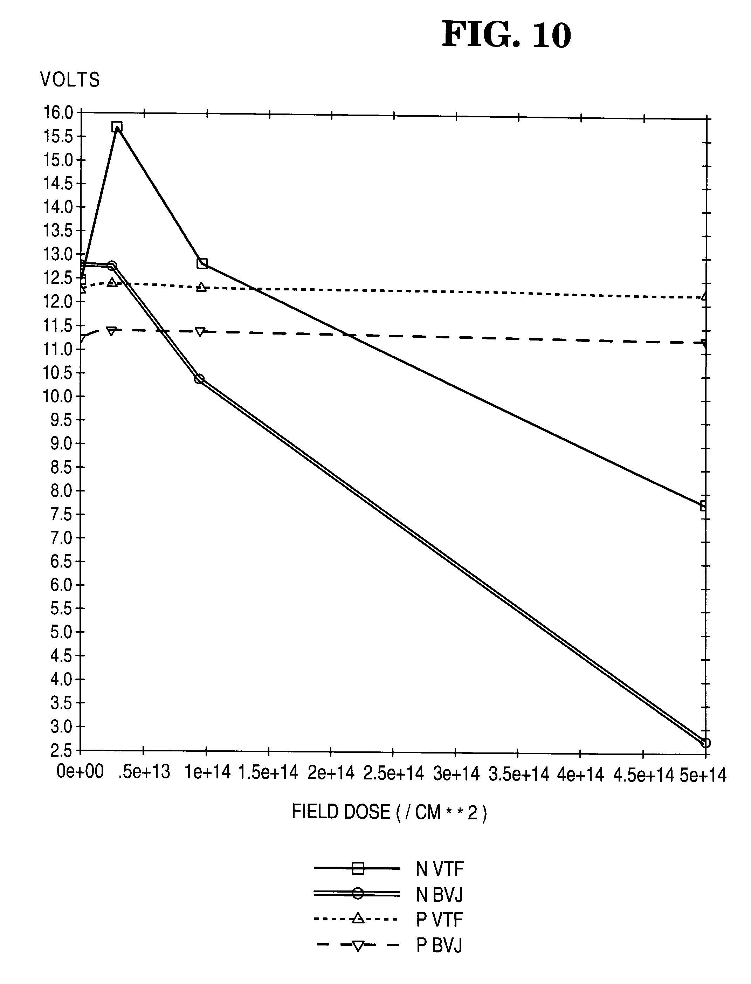

FIG. 10 is a graph showing breakdown voltage (BVJ) and field threshold voltage (VTF) for N-type devices with a field implant and P-type devices without a field implant. As can be seen from the solid lines, increasing field implant dosage lowers both the breakdown voltage and the threshold voltage.

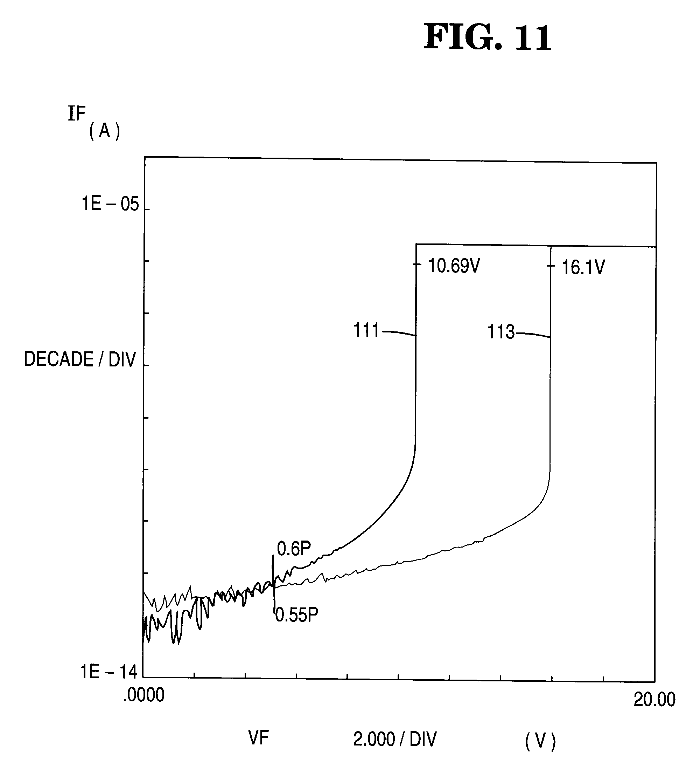

FIG. 11 is a graph showing current/voltage relationships for thick field devices operating at 85 degrees C with a field implant 111 and without a field implant 113. The device with a field implant is fully on by 10.69 volts, while the device without the field implant is fully on at 16.1 volts.

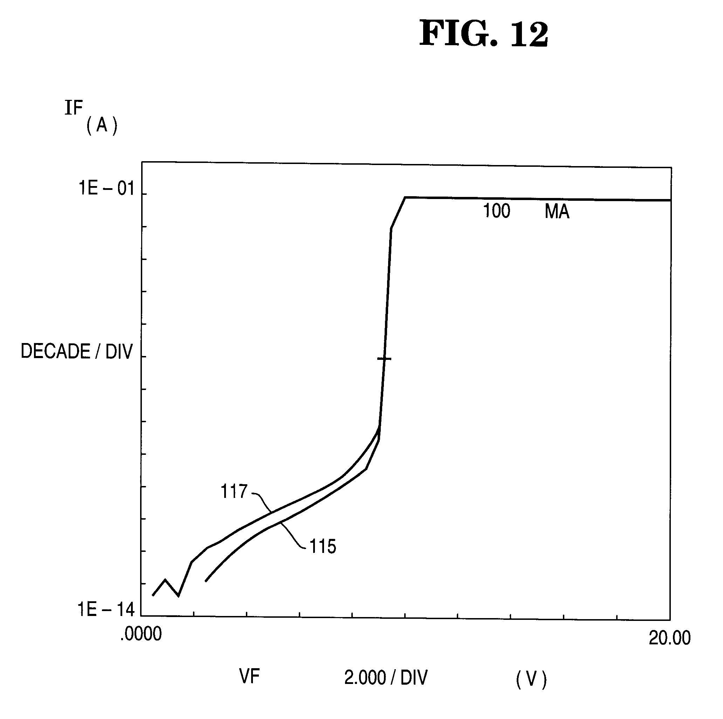

FIG. 12 is a current/voltage relationship for a repeatedly-stressed thick field device with field implant. The first trace 115 is the response of a test device with field implant during the first ESD event. The second trace 117 is the repose of the same device during the tenth ESD event. The relatively small change in device characteristics shows that the device can be stressed repeatedly. The device heats slightly after the first breakdown due to current heating.

A device without the field implant was tested and found to survive a first ESD event of 100 microamps, but failed during the second ESD event of about 0.5 microamps. It is believed that the failure was caused by power dissipation by the device and localized heating.

The effect of the field implant on device survivability can be appreciated once it is recognized that power dissipation is the product of current and voltage (P = I x V). A device with field implant breaks down at a lower voltage. It therefore dissipates less power for a given current and experiences less localized heating.

Power can also be expressed as the product of resistance times the square of the current (P = I² x R). The field implant lowers the resistance in the field region, and thus results in lower power dissipation.

Heating also makes a conductive region more resistive. Thus, the greater heating in the device without implant may be further compounded in an effect known as "thermal runaway." The device continues to heat until either: a) the contacts are destroyed (about 500 degrees C), or b) the junction melts (about 1200 degrees C).

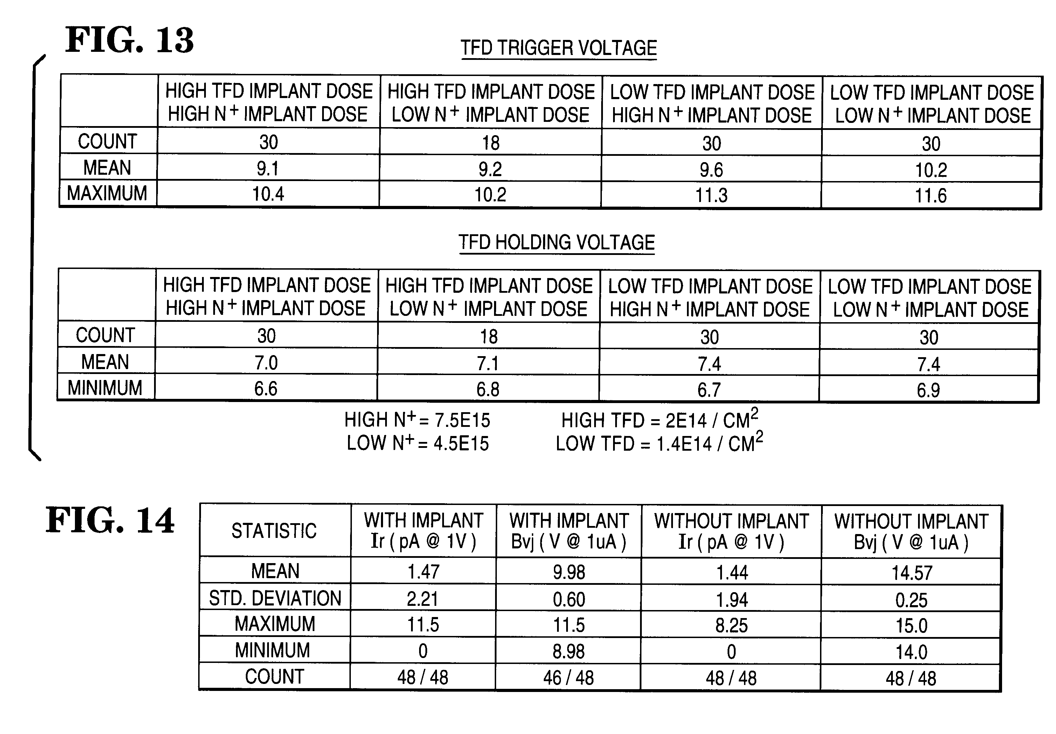

FIG. 13 is a two-part table showing trigger voltage and holding voltage for batches of thick field devices for varying combinations of field implant doses and N+ implant doses. The minimum observed holding voltage is 6.6 volts, which is appropriate for a process in which VDD max is about 6.5 volts. The thick field device will not latch as long as VDD is less than 6.5 volts.

FIG. 14 is a table showing leakage current and breakdown voltage for thick field devices with and without field implants. As can be seen from the second and fourth columns, the mean thick field device breakdown voltage is 9.98 volts with a field implant of 1.7E14/cm2 (boron) at 40 keV. Without the implant, the mean breakdown voltage is 14.57 volts. The first and third columns of FIG. 14 show that leakage current is about 1.5 pico-amps (regardless of field implant), and that devices with field implant retain a suitably low leakage.

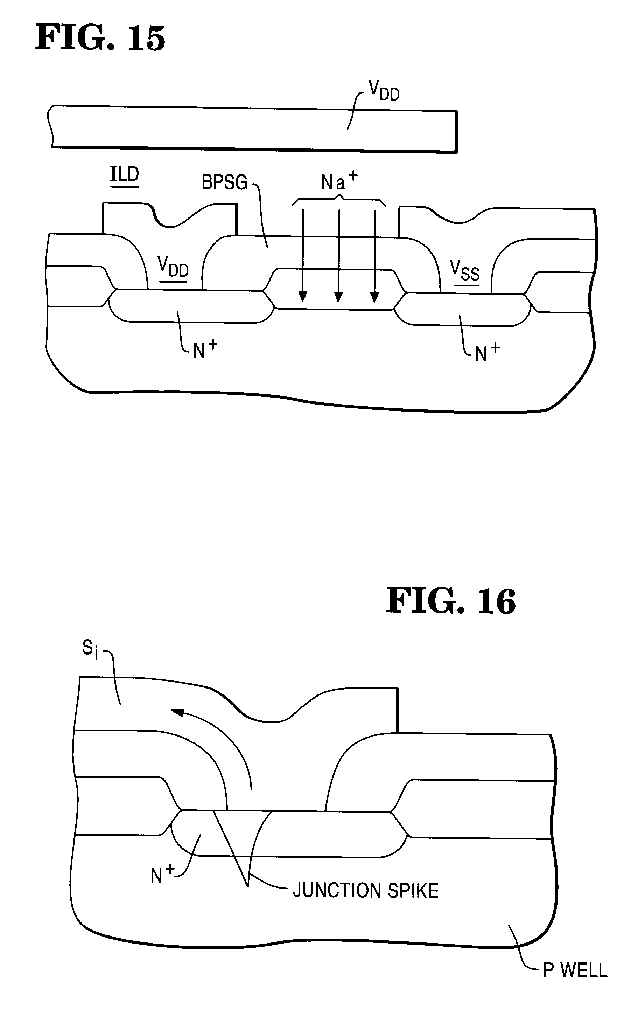

As shown in Fig. 1A, the thick field device has a metal Vss connection which extends over the field oxide of the thick field device. The field oxide operates as a floating base. Without the metal extension, sodium ions tend to migrate toward the inter-layer dielectric film to the field-oxide/silicon interface. If the sodium content of the dielectric film exceeds 2E12/cm2, the sodium ions will move under thermal and voltage stress of an ESD event as shown in FIG. 15. At the field-oxide/silicon interface, the ions cause parasitic MOS action, leading to a leakage current.

The metal layer extending over the field provides a barrier to ion migration, and shields the field oxide from the potential caused by ion contamination in the interlayer dielectric.

As also shown in Fig. 1A, the thick field device includes N-wells under the metal contacts to prevent junction spikes. At high temperatures, silicon dissolves in aluminum. The effect on circuits is that silicon is removed from the junction and diffuses into the contacting metal. If the junction spike formed by this process extends deeper than the silicon junction, the metal contacts the well under the junction. For a P+ junction to an N well (or N substrate), a good shottky diode forms and the quality of the junction is preserved. But for an N+ to P well (or P-substrate), the shottky diode is poor and a leakage path from to the well (or substrate) is formed as shown in Fig. 16.

Although a metal contact is stable up to about 500 degrees C, heating can occur during an ESD event and destabilize the metal/silicon contact. By placing an extended N well under the N+ region at the location where the metal contacts the N+ region, a junction spike will not reach the underlying P substrate.

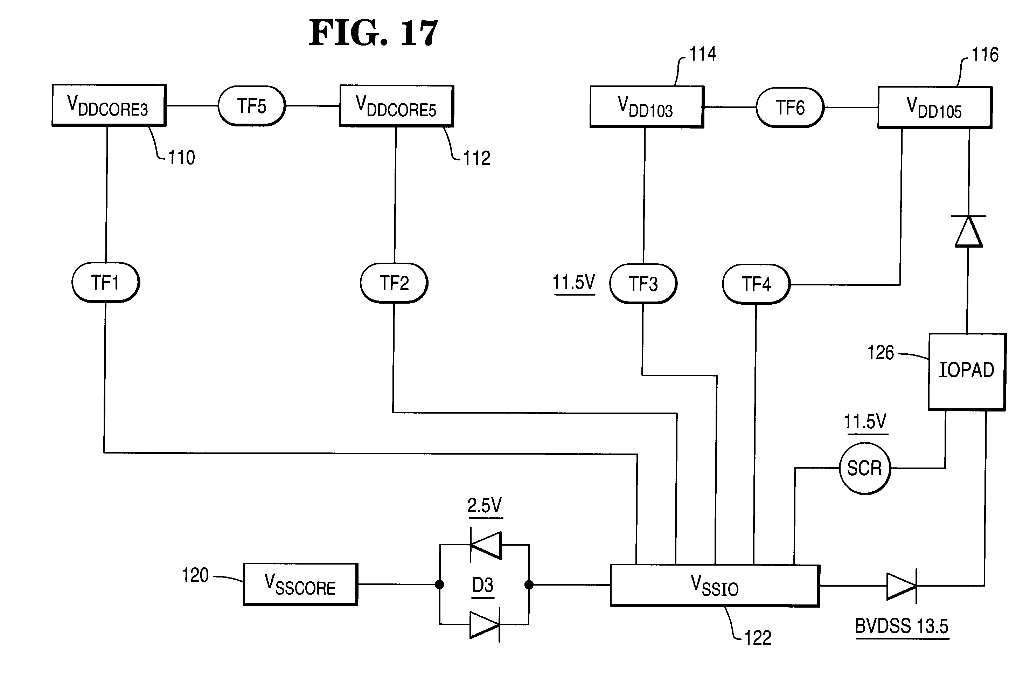

FIG. 17 is schematic diagram for an application of a thick field device in an integrated circuit for ESD protection. This application relates to Application Specific Integrated Circuits (ASICs); however, it should be understood that the invention is in no way limited to such an environment and may in fact be utilized in any circuit environment in which ESD protection is appropriate and in which fabrication technologies permit.

ASICs often use separate power supplies for I/O circuitry and core logic circuitry, or separate power supplies for digital circuitry and analog circuitry. Additionally, an ASIC may use a relatively high voltage power supply for powering components designed to operate at high speed, and a relatively low power supply for powering components designed to operate at a relatively low speed. In the ensuing discussion, the following table of abbreviations will denote these voltages:

| | |
|---|---|
| VDDIO5 | 5V V_{DD} for peripheral I/O circuitry; |
| VDDIO3 | 3.3V V_{DD} low power for peripheral I/O circuitry; |
| VDDCORE5 | 5V V_{DD} for core logic circuitry; |
| VDDCORE3 | 3.3V V_{DD} low power for core logic circuitry; |
| VDDA | V_{DD} for analog circuitry; |
| VSSIO | I/O circuitry ground; |
| VSSCORE | Core logic circuitry ground; |
| VSSA | Analog circuitry ground; |

As seen in FIG. 17, the IC has a VDDCORE3 +3.3V low power core logic circuitry pad 110, a VDDCORE5 +5V core logic circuitry pad 112, a VDDIO3 +3.3V low power peripheral I/O circuitry pad 114, a VDDIO5 +5V peripheral I/O pad 116, a VDDA V_{DD} analog circuitry pad (not shown), a VSSCORE core circuitry ground pad 120, a VSSIO I/O circuitry ground pad 122, and a VSSA analog circuitry ground pad (not shown). The IC also has a plurality of pads IOPAD 126 for connection of various IC components to external elements. Only one such pad 126 has been shown in the figure for simplicity and clarity.

Thick field devices TF1, TF2, TF3, TF4, TF5, and TF6 are positioned to shunt current from ESD pulses that may occur between a variety of combinations of pads. (Another thick field device may similarly be used with VSSA and VDDA). Also shown are diodes D3 and an SCR.

The invention is not restricted to the details of the foregoing embodiment. For example, although an ASIC with separate power supplies has been described, the thick field device may be adapted to other integrated circuit designs. Also while an NMOS device has been described, the thick field device can be adapted to PMOS and CMOS applications. The embodiments described above are exemplary but not intended to limit unduly the scope of the invention as defined by the following claims.

## Claims

1. A thick field device for limiting a voltage between first and second conduction paths to below a required level characterised by first (21) and second (23) semiconductor regions of a first dopant type separated by a third semiconductor region (25) of a second dopant type, the first semiconductor region (21) being arranged for connection to the first conduction path at a first contact location, the second semiconductor region (23) being arranged for connection to the second conduction path at a second contact location, a field oxide region (21) overlying the third semiconductor region and a field implant region (29) provided within the third semiconductor region (25), the field implant region having a concentration of the second dopant type sufficient to reduce a trigger voltage of the thick field device to below said required level.

2. A device as claimed in Claim 1, wherein the concentration of the second dopant type in the field implant region (29) is greater than about 1E14/cm2.

3. A device as claimed in Claim 1, wherein the concentration of the second dopant type in the field implant region is between about 1E14/cm2 and about 5E14/cm2.

4. A device as claimed in Claim 1, wherein the concentration of the second dopant type in the field implant region is about 1.7E14/cm2.

5. A device as claimed in any one of Claims 1 to 4, wherein the second conduction path includes metal, and the device further comprises a first well (37) of the first dopant type extending the depth of the first semiconductor region beneath the first contact location.

6. A device as claimed in any one of Claims 1 to 4, wherein the second conduction path includes aluminum, and the device further comprises a first well (37) of the first dopant type extending the depth of the first semiconductor region beneath the first contact location.

7. A device as claimed in any one of Claims 1 to 4, wherein the first conduction path is made of metal, the first semiconductor region (21) extends beneath the first contact region by an amount less than about 2 microns, and the device further comprises a first well (37) of the first dopant type extending the depth of the first semiconductor region to a depth of at least about 2 microns beneath the first contact location.

8. A device as claimed in any one of the preceding claims and further comprising a metal barrier located over the field oxide.

9. A device as claimed in any one of Claims 1 to 7 and further comprising a sodium-bearing interdielectric layer (95) above the field oxide (83) and a metal layer (93) located between the field oxide (83) and the interdielectric layer (95).

10. A device as claimed in any one of the preceding claims, wherein the first conduction path is at a lower potential than the second conduction path and a metal barrier is connected to the first conduction path.

11. An integrated circuit comprising first and second conduction paths connected to first and second power terminals (110, 112), a plurality of semiconductor devices susceptible to damage from an over-voltage level between the first and second conduction paths, and characterised by a thick field device (TF1, TF2, TF3, TF4, TF5, TF6) as claimed in any one of the preceding claims and wherein the respective first and second conduction paths are electrically connected.
